Europäisches Patentamt

European Patent Office

Office européen des brevets

(19)

(11) **EP 0 954 033 A1**

(12) **EUROPÄISCHE PATENTANMELDUNG**

(43) Veröffentlichungstag:
    **03.11.1999 Patentblatt 1999/44**

(51) Int. Cl.⁶: **H01L 31/032**, C30B 25/00,
    C30B 25/02, C30B 29/46

(21) Anmeldenummer: **98810382.6**

(22) Anmeldetag: **29.04.1998**

(84) Benannte Vertragsstaaten:
    **AT BE CH CY DE DK ES FI FR GB GR IE IT LI LU
    MC NL PT SE**
    Benannte Erstreckungsstaaten:
    **AL LT LV MK RO SI**

(71) Anmelder:
    **La Vecchia, Nunzio, Dr.
    6612 Ascona (CH)**

(72) Erfinder:
    **La Vecchia, Nunzio, Dr.
    6612 Ascona (CH)**

(74) Vertreter: **Luchs, Willi
    Luchs & Partner,
    Patentanwälte,
    Schulhausstrasse 12
    8002 Zürich (CH)**

(54) **Halbleiterbauelement, insbesondere eine Solarzelle, mit einer Schicht aus Pyrit, sowie Verfahren zu dessen Herstellung**

(57)     Ein Halbleiterbauelement (50), welches insbesondere als Solarzelle ausgebildet ist, hat mindestens ein aus einem Mono- oder einem Poly-Kristallgefüge bestehendes Halbleiter-Basismaterial (40). Das Halbleiter-Basismaterial (40) besteht zumindest teilweise aus Pyrit mit der chemischen Zusammensetzung $FeS_2$, welches zur Erzielung eines definierten Reinheitsgrades gereinigt ist. Das Halbleiter-Basismaterial (40) ist sehr vorteilhaft aus wenigstens einer Schicht Pyrit (51), wenigstens einer Schicht Bor (52) und wenigstens einer Schicht Phosphor (53) zusammengesetzt. Mit diesem Halbleiterbauelement ergibt sich eine optimale Ausführung insbesondere, wenn dieses als Solarzelle benutzt wird.

Fig.3

EP 0 954 033 A1

**Beschreibung**

Die Erfindung betrifft ein Halbleiterbauelement, insbesondere eine Solarzelle, mit mindestens einem aus einem Mono- oder einem Poly-Kristallgefüge bestehenden Halbleiter-Basismaterial, das wenigstens eine p-Schicht und wenigstens eine n-Schicht hat.

Es sind bereits eine Anzahl gattungsmässiger Halbleiterbau- oder Halbleiterphotoelemente bekannt, mittels welchen durch Ausnutzung des inneren Photoeffektes Strahlungsenergie der Sonne oder von Licht bei einem Wirkungsgrad bis annähernd 15 % eine kommerzielle Nutzung erfolgt. Als Halbleitermaterialien werden vorwiegend dünne Silizium- oder Galliumarsenid-Einkristalle mit p- und n-leitenden Zonen verwendet.

Es sind auch Dünnschicht-Solarzellen bekannt, bei welchen die Halbleiterschichten auf einen Träger mittels Aufdampfen oder ähnlichem mit einer Stärke im Mikrometerbereich (1 bis 50μm) aufgebracht werden. Hierzu werden für diese Halbleiterschichten Materialien, wie Cadmiumsulfid, Cadmiumtellurid, Kupfersulfid oder ähnliche verwendet. Mit diesen Halbleiterbauelementen wird jedoch nur ein Wirkungsgrad von ca. 5 - 8% erreicht. Sie weisen aber ein günstiges Leistungsgewicht auf und sind gegenüber den Silizium-Einkristallen wesentlich günstiger herstellbar.

Der vorliegenden Erfindung wurde demgegenüber die Aufgabe zugrundegelegt, ein Halbleiterbauelement insbesondere eine Solarzelle nach der eingangs erwähnten Gattung zu schaffen, mittels welchem gegenüber den bekannten bei Sonnen- oder Lichteinstrahlung ein höherer Wirkungsgrad erzielt wird. Ferner sollen mit diesem Halbleiterbauelement die Herstellungskosten so niedrig sein, dass eine aus diesem hergestellte Solarzelle sich u.a. für Massenartikel eignet. Ein weiteres Ziel der Erfindung besteht ausserdem darin, ein Halbleitermaterial zu verwenden, welches leicht und umweltschonend entsorgt werden kann.

Die Aufgabe ist erfindungsgemäss dadurch gelöst, dass das HalbleiterBasismaterial zumindest teilweise aus Pyrit mit der chemischen Zusammensetzung $FeS_2$ besteht, welches zur Erzielung eines definierten Reinheitsgrades gereinigt ist.

Mit diesem erfindungsgemässen Halbleiterbauelement lassen sich Solarzellen herstellen, welche gegenüber all den bekannten einen höheren Wirkungsgrad aufweisen. Das als Halbleitermaterial verwendete Pyrit hat den Vorteil, dass es als natürliches Material vorkommt oder dass es sich auch synthetisch herstellen lässt. Die Herstellungskosten können in einem solchen Rahmen gehalten werden, dass sich aufgrund der Wirkungsgraderhöhung eine nutzbringende Verwendung ergibt.

Bei einer sehr vorteilhaften Ausführung ist das Halbleiter-Basismaterial aus wenigstens einer Schicht Pyrit, wenigstens einer Schicht Bor und wenigstens einer Schicht Phosphor zusammengefügt. Mit der Verwendung dieser drei Basismaterialien ergibt sich insbesondere für Solarzellen eine optimale Zusammensetzung.

Ausführungsbeispiele der Erfindung sowie weitere Vorteile derselben sind nachfolgend anhand der Zeichnung näher erläutert. Es zeigt:

Fig. 1 einen schematischen Querschnitt durch ein erfindungsgemässes Halbleiterbauelement in vergrösserter Darstellung,

Fig.2 eine schematische Darstellung der Energieaufspaltung der Fe d-Zustände im oktaedischen und verzerrt oktaedischen Ligandenfeld des Pyrit,

Fig.3 einen schematischen Querschnitt durch ein erfindungsgemässes Halbleiterbauelement mit einem Heteroübergang in vergrösserter Darstellung, und

Fig.4 eine schematische Darstellung der Energiebänder bei einem Heteroübergang eines erfindungsgemässen Halbleiterbauelementes.

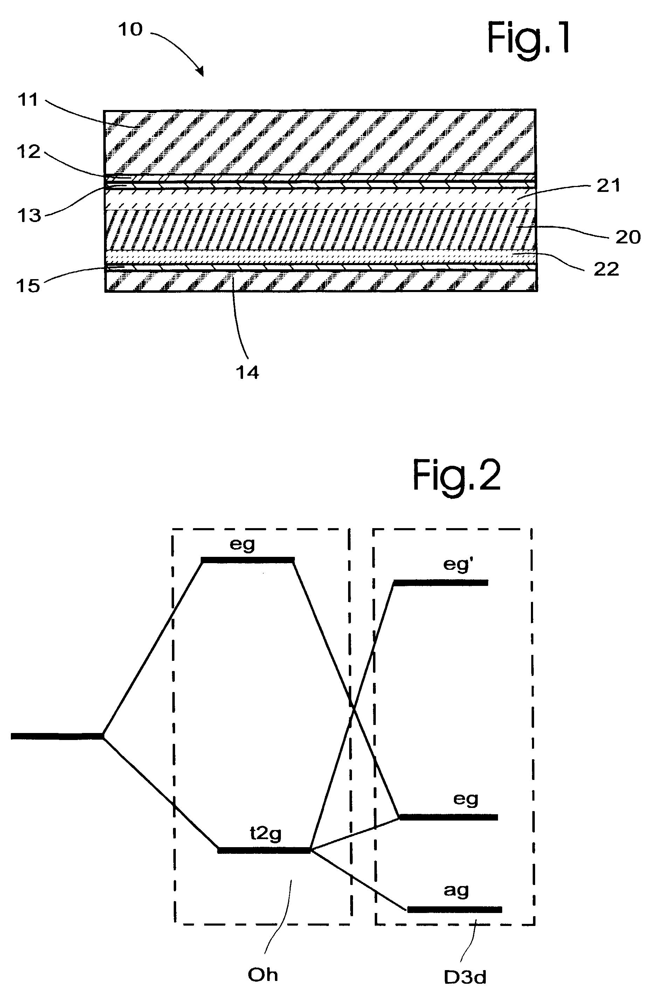

Fig. 1 zeigt schematisch ein erfindungsgemässes Halbleiterbauelement 10, welches insbesondere als Solarzelle ausgebildet ist. Dieses Halbleiterbauelement 10 besteht im vorliegenden Ausführungsbeispiel aus einer mehrschichtigen Struktur und es kann beispielsweise zusammen mit einer Anzahl von nebeneinander angeordneten Zellen in einem als Panel ausgebildeten Metallgehäuse eingekapselt sein, was nicht im Detail dargestellt ist. Die Solarzelle weist vorzugsweise eine Abdeckplatte mit einem durchsichtigen Werkstoff, z.B. einer Glasschicht 11 oder ähnlichem auf, hierdurch diese Zelle gegen mechanische Krafteinwirkungen, wie Schläge etc., gegen Feuchtigkeit und/oder Witterungseinflüsse generell geschützt ist.

Erfindungsgemäss besteht das Halbleiter-Basismaterial 20 aus Pyrit oder Eisenkies, welches eine chemische Zusammensetzung von $FeS_2$ hat. Das Halbleiter-Basismaterial 20 soll mit wenigstens einer p- und wenigstens einer n-Schicht versehen sein, wobei im gezeigten Beispiel das Halbleiter-Basismaterial aus der einen $FeS_2$ Schicht besteht.

Als Abdeckung des Halbleiterbauelementes 10 ist eine Glasschicht 11 vorgesehen, welche bspw. an dem nicht näher gezeigten Metallgehäuse befestigt ist. Eine Laminatschicht 12, bspw. aus Harz, umschliesst zusammen mit einem auf der Unterseite angeordneten, z.B. als Keramikplatte ausgebildeten Isolator 14 die Solarzelle, damit das Innere der Solarzelle abgeschlossen und demnach undurchlässig gegen Feuchtigkeit, Wasser oder dergleichen ist.

Das eigentliche Halbleiterbauelement setzt sich aus dem aus reinstem Pyrit bestehenden Halbleiter-Basismaterial 20, einer p-Schicht 21 und einer n-Schicht 22 zusammen. Das eine Leitermaterial 13 (+) grenzt an die p-Schicht 21, indessen dass andere Leitermaterial 15 (-)an der n-Schicht 22 angeschlossen ist, wobei das Leitermaterial 15 vom Isolator 14 abgeschirmt ist. Diese Leitermaterialien sind über nicht näher gezeigte Leitungen mit einem Verbraucher jeglicher Art verbunden.

Fig. 1 ist als Solarzelle mit einem im Rahmen der Erfindung einfachen Strukturaufbau dargestellt. Selbstverständlich könnten auch sowohl die Leitermaterialien als auch die Halbleiterschichten in unterschiedlicher Konfiguration und Anzahl vorgesehen sein.

Ein solches Halbleiterbauelement kann als Solarzelle für die verschiedensten Ausführungen verwendet werden, sei es für sehr kleine Zellen, bspw. für Taschenrechner, als auch für Solarzellen zur Heizung von Häusern und für Grossanlagen, mittels welchen insbesondere die Sonnenenergie in elektrischen Strom umgewandelt wird.

Bei Pyrit oder Eisenkies als natürlich vorkommendes Gestein handelt es sich um das meistverbreitete Sulfid auf der Erde, welches beispielsweise in Spanien als hydrothermal entstandenes Erzgebiet existiert. Die einzelnen Kristalle des Pyrits sind messing- oder mörtelfarbig und sehr hart, deren Mohs'sche Härte ca. 6 bis 6.5 beträgt. Pyrit hat einen thermischen Ausdehnungskoeffizienten bei 90 bis 300 K von $4.5 \times 10^{-6}$ K$^{-1}$ und bei 300 bis 500 K von $8.4 \times 10^{-6}$ K$^{-1}$. Der die chemische Zusammensetzung $FeS_2$ aufweisende Pyrit hat eine Elementarzelle von 12 Atomen und eine Länge der Einheitszelle von annähernd 5.4185 Angström. Die typischen Grundformen des Kristallhabitus des Pyrits treten als Würfel, als kubische Form, als Pentagondodekaeder oder als Oktaeder auf. Ein weiterer Vorteil dieses Halbleiterbauelementes besteht darin, als dieser Pyrit eine gute Umweltverträglichkeit aufweist.

Mit Bezug auf die Wirkungsweise dieser erfindungsgemässen Solarzelle 10 werden nach den allgemein gültigen Regeln der Quantenmechanik nur solche Lichtquanten wirksam, deren Energie mindestens gleich der Breite der verbotenen Zone und höchstens gleich der Energiedifferenz zwischen unterer Kante des Valenzbandes und oberer Kante des Leitungsbandes ist. Die Menge der erzeugten Ladungsträger im Halbleiter hängt neben der Energie und der Anzahl pro Flächeneinheit der eingestrahlten Photonen vom Absorbtionskoeffizienten a des Halbleiters ab. Pyrit verfügt im Vergleich zu herkömmlichen Halbleitermaterialien über einen sehr hohen Absorptionskoeffizienten, welcher bei der Bandkante bei $\alpha > 10^5$ cm$^{-1}$ für $\lambda < 1\mu m$ liegt. Mit der Ausbildung des Halbleiterbauelementes 10, 50 nach der Erfindung hat man sich diese Eigenschaft des Pyrits vollauf zu Nutze gemacht.

Gemäss Fig.2 ist die Energieaufspaltung der Fe d-Zustände im oktraedischen $O_h$ und verzerrt oktraedischen $D_{3d}$ Ligandenfeld ersichtlich. Es wird hierbei eine Bandlücke des Halbleiter-Basismaterials durch die Aufspaltung der Fe d-Zustände in besetzte $t_{2g}$- und unbesetzte $e_g$-Zustände gebildet, wobei diese Bandlücke bis 0.7 eV oder mehr beträgt. Das Valenzband hat eine Breite von 0.8 eV oder mehr und die darunter liegende Gruppe ist durch eine Lücke von ebenfalls ca. 0.8 eV getrennt. Die Zustände oberhalb des Leitungsbandes haben ihren Ursprung in Fe 4s und 4p Zuständen. Im Bereich der Molekülorbitaltheorie wird die Energielücke bei Pyrit durch das Aufspalten der 3d-Zustände des Eisens in energetisch nieder besetzte $t_{2g}$- und unbesetzte $e_g$-Zustände erzeugt. Die Aufspaltung wird durch das oktraedische Lingandenfeld des Schwefels verursacht, das leicht verzerrt ist und zu einer weiteren, hier jedoch unwesentlicher Aufspaltung der Energieniveaus führt.

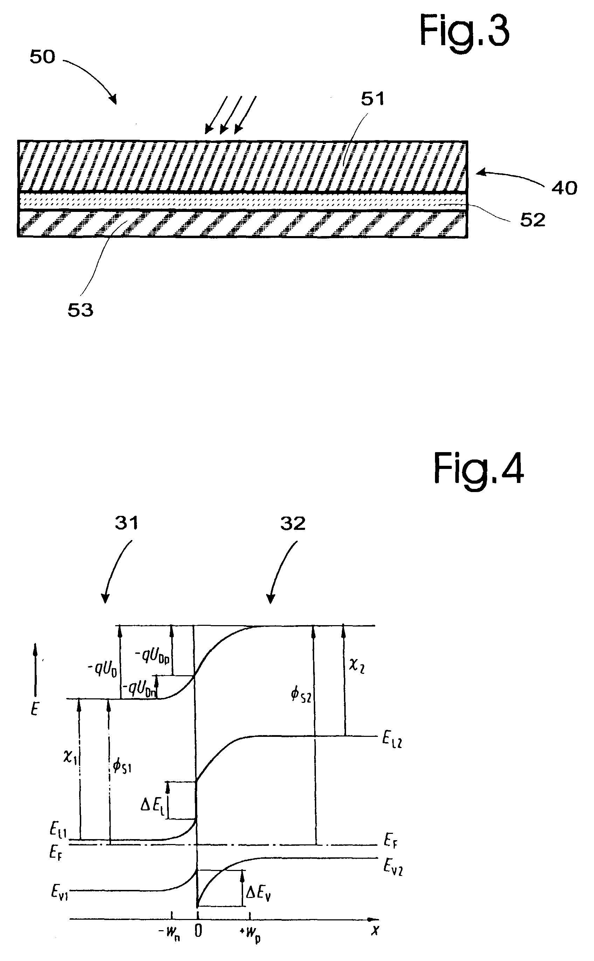

Fig.3 zeigt einen Querschnitt eines erfindungsgemässen Halbleiterbauelementes 50, welches ein mehrschichtiges Halbleiter-Basismaterial 40 aus wenigstens einer oberen Schicht Pyrit 51, einer Schicht Bor 52 und einer Schicht Phosphor 53 zusammengefügt ist. Der Pyrit 51 ist hierbei auf der Aussenseite angeordnet, bei welcher die einwirkende Sonneneinstrahlung oder dergleichen als erste aufgenommen werden. Die Leiterelemente können derart angeordnet sein, dass sie die einzelnen Schichten 51, 52, 53 einzeln abgreifen, was nicht näher dargestellt ist.

Im Unterschied zu der in Fig.3 schichtweise hergestellten HalbleiterBasismateriales 40 könnten eine oder mehrere Schichten Bor und/oder eine oder mehrere Schichten Phosphor quer in der zum Beispiel als Einkristall erzeugten Pyrit-Targets angeordnet sein.

Die Halbleiter-Basismaterialien 20 bzw. 40 zu diesen erfindungsgemässen Solarzellen 10, 50 können auf verschiedene Arten hergestellt werden. Der Pyrit in der Zusammensetzung von $FeS_2$ kann entweder aus natürlichem Vorkommnis gewonnen oder aus Eisen und Schwefel synthetisch hergestellt oder gezüchtet werden.

Bei der Verwendung von natürlichen Pyritkristallen als HalbleiterBasismaterial 20 muss dieses Pyrit, welches eine Nettoladungsträgerkonzentration von ca. $10^{15}$ cm$^{-3}$ hat, in an sich bekannter Weise mehrfach zonengereinigt werden, damit es einen definierten Reinheitsgrad von 99,9 $\bar{9}$% erreicht.

Für die künstliche Herstellung oder Züchtung des Halbleiter-Basismateriales Pyrit sind verschiedene Methoden anwendbar, wobei die Ausgangsmaterialien ebenfalls bereits durch eine Mehrfach-Zonenreinigung behandelt sind, um eine höchstmögliche Reinheit nach der chemischen Verbindung derselben zu erreichen.

Als Herstellungsmethode eignet sich u.a. der Gasphasentransport (CVT), bei dem der Temperaturgradient beim Erzeugen der EisenSchwefelverbindung zwischen 250° und 1200°C liegen soll. Wenn Pyrit als natürliches Ausgangsmaterial verwendet wird, kann auf der kälteren Seite die Temperatur zwischen 250° und 850°C variieren. Als Transportmittel für die Beschickung von Schwefel im Eisen kann beispielsweise Brom ($Br_2$, $FeBr_3$) oder ein anderer Werkstoff genommen werden.

Die Kristallzucht erfolgt beispielsweise in einer NatriumpolysulfidLösung. Das Pyrit lässt sich aus den gereinigten Ausgangselementen Eisen und Schwefel neben dem Standardtemperaturgradienten zwischen 250° und 1200°C auch in einem Gradienten von 200° bis 1400°C züchten. Diese CVT-Methode bietet eine erhöhte Reproduzierbarkeit bei der Herstellung und es können mit ihr absolut reine Kristalle erzeugt werden.

Bei der Erzielung von grossen einkristallinen Pyritstücken wird vorzugsweise das Herstellungsverfahren via Schmelzlösung mit Tellur, $BrCl_2$, $Na_2S_2$ oder ähnliche Materialien verwendet.

Eine weitere Herstellungsvariante von Pyrit besteht in dem RF-Sputtern. Dies erfolgt in einer Sputteranlage, bei der ein Pyrittarget mit einem Argon-Schwefel-Plasma gesputtert wird. Der Argonfluss beträgt in der Regel zwischen 0.1 und 300 ml/min und der Schwefel wird durch das Verdampfen von elementarem Schwefel beigesetzt. Beim Abscheiden ist der Arbeitsdruck von 0.01 mbar oder mehr oder auch weniger gehalten worden. Das verwendete Self-Bias-DC-Potential auf 0 bis 400 Volt eingestellt. Die Substrattemperatur ist von 80° bis 950°C gewählt worden. Mit diesem Verfahren kann grundsätzlich auch ein Poly-Kristallgefüge erzeugt werden.

Zur Herstellung von erfindungsgemässen Halbleiterbauelemente als Dünnfilme kann man ein inkongruentes Materialsystem verwenden. Es eignet sich das reaktive Sputtern von einem Target aus Pyrit, die MOCVD-Methode und die Spray-Pyrolyse. Ausserdem kann mittels der Methode des thermischen Verdampfens mit Hilfe eines Fördersystems, welches ständig kleine Mengen von einem Pulvergemisch in die heisse Verdampfungsquelle einbringt, gewährleistet werden, dass das Material, bedingt durch die hohe Temperatur nahezu vollständig verdampft. Bei dieser Art des Verdampfens ergibt sich der Vorteil, dass auf die Stöchiometrie und eine mögliche Dotierung Einfluss genommen werden kann, da man z.B. den Dotierstoff direkt zum Pulvergemisch zugeben kann. Bei einer Sulfersierung von Eisenfilmen, sei es nun rein thermisch oder mit Hilfe eines Plasmas, ist es möglich, von sehr reinen Ausgangsmaterialien auszugehen.

Die Dicke der aktiven Schicht hat einen grossen Einfluss auf den Wirkungsgrad der Solarzelle. Zur Abschätzung des Wirkungsgrades und der dafür erforderlichen Zellenparameter lassen sich entsprechende Grenzbereiche festlegen.

Für die Dotierung der p-Schicht des Halbleiter-Basismateriales wird ein Material aus der Gruppe V des Periodensystems der Elemente, vorzugsweise Phosphor, Antimon oder Arsen benutzt. Diese p-Schicht wird vorteilhaft durch einen Anteil des Materials aus der Gruppe V in einem Massen-Prozentsatz von 0.001 bis 20 % des Basismaterials. Dies hängt von den angestrebten Eigenschaften des gefertigten Halbleiterbauelementes ab. Das Antimon und Phosphor werden dabei in einer Konzentration im Bereich von 0.011 bis 12 Massenprozenten des Basismaterials anstelle des Schwefels in das Kristallgitter eingebaut.

Die Dotierung des via die CVT-Methode erzeugten Pyrit kann in verschiedenartiger Weise erfolgen. Als Ausgangselemente für diese Dotierung werden vor allem die Elemente S, O, N, H, Sn, C, Si, Co oder andere herbeigezogen.

Bei der Zucht von p-leitenden Kristallen werden die Ausgangselemente Fe und S sowie die Elemente Antimon und Phosphor aus der Gruppe V des Periodensystems genommen, wobei diese Elemente anstelle von Schwefelatomen in das Kristallgitter eingesetzt sind. Hierdurch werden diese mit einem in der äusseren Elektronenschale gegenüber der Schwefelatomen fehlenden Elektron die Löcher gebildet.

Das erfindungsgemässe Halbleiterbauelement könnte auch als sogenannte Tandemzelle gefertigt sein. Hierbei könnte beispielsweise eine p- und n-Schicht aus Pyrit und eine weitere p- und n-Schicht aus einem anderen Halbleiterkristall, wie zum Beispiel aus Silizium, aus Galliumarsenid oder aus einem anderen wählbaren Material zusammenwirken. Mit einem solchen Halbleiterbauelement könnte eine maximale Ausnutzung des Sonnenspektrums erreicht werden, wenn mit diesen unterschiedlichen Halbleiter Basismaterialien eine Abdeckung der Energielücke zwischen 1,0 und 1,8 eV erfolgen würde.

Gemäss Fig.4 können im Rahmen der vorliegenden Erfindung auch Heteroübergänge zwischen unterschiedlichen Halbleitermaterialien benutzt werden, wie dies bereits oben zu der Ausführungsvariante gemäss Fig.3 ausführlich erläutert ist. Voraussetzung hierfür ist jedoch, dass die Gitterkonstanten und deren thermische Ausdehnungskoeffizienten beider Stoffe nicht zu stark voneinander abweichen. Als Beispiel könnte erfindungsgemäss ein p-Halbleiter 31 aus Pyrit mit einem n-leitenden Halbleiter 32 aus einem andern Material kombiniert werden. Mit diesem Heteroübergang ist eine Banddiskoniuität herbeigeführt worden, mit Hilfe derer in einer neuartigen Weise auf den Ladungsträgertransport eingewirkt werden kann. Mit den beiden getrennten Halbleitermaterialien 31 und 32 sind die Bandlücken $E_G$, die Austrittsarbeiten $\phi s$ sowie die Elektronenaffinitäten $\chi$ unterschiedlich.

Für die Herstellung von Heteroübergängen sind speziell entwickelte Epitaxieverfahren bekannt, welche auch mit Bezug auf die in der vorliegenden Erfindung verwendeten Halbleiter-Basismaterialien benutzt werden. Zum einen gibt es die Molekularstrahlepitaxie (MBE) und zum andern die Gasphasenepitaxie (MOCVD) in der Form der Gasphasenabscheidung aus metall-organischen Verbindungen.

Das Halbleiterbauelement kann bei einer mehrschichtigen Struktur bis zu annähernd hundert Schichten aufweisen. So wäre beipsielsweise denkbar, dass das Halbleiterbauelement nach der Fig.3 aus mehr als drei unterschiedlichen Schichten gebaut sein könnte, so zum Beispiel könnten mehrere Schichten aus Pyrit und gegebenenfalls auch mehrere Schichten aus Bor bzw. Phosphor vorhanden sein.

Mit Bezug auf die Wirkungsweise dieser erfindungsgemässen Solarzelle 10, 50 werden nach den allgemein gültigen Regeln der Quantenmechanik nur solche Lichtquanten wirksam, deren Energie mindestens gleich der Breite der verbotenen Zone und höchstens gleich der Energiedifferenz zwischen unterer Kante des Valenzbandes und oberer Kante des Leitungsbandes ist. Die Menge der erzeugten Ladungsträger im Halbleiter hängt neben der Energie und der Anzahl pro Flächeneinheit der eingestrahlten Photonen vom Absorbtionskoeffizienten a des Halbleiters ab. Pyrit verfügt im Vergleich zu herkömmlichen Halbleitermaterialien über einen sehr hohen Absorptionskoeffizienten, welcher bei der Bandkante bei $\alpha > 10^5$ cm$^{-1}$ für $\lambda < 1$ µm liegt. Mit der Ausbildung des Halbleiterbauelementes 10, 50 nach der Erfindung hat man sich diese Eigenschaft des Pyrits vollauf zu Nutze gemacht.

Das als Pyrit verwendete Halbleiter-Basismaterial lässt sich - wie oben bereits erwähnt - im Rahmen der Erfindung lässt sich nicht nur als Einoder Mehrschicht-Solarzelle, sondern auch als Dünnfilm-Solarzelle, als MIS-Solarzelle, als photochemische Zelle oder dergleichen ausbilden.

Sehr vorteilhaft wird das Halbleiterbauelement nach der Erfindung als Solarzelle genutzt, weil es als solches einen ausserordentlichen hohen Wirkungsgrad erzielt. Selbstverständlich könnte dieses Halbleiterbauelement auch für andere Zwecke, wie beispielsweise als Diode, Transistor, Thyristor oder dergleichen verwendet werden.

## Patentansprüche

1. Halbleiterbauelement, insbesondere eine Solarzelle, mit mindestens einem aus einem Mono- oder einem Poly-Kristallgefüge bestehenden Halbleiter-Basismaterial (20), das wenigstens eine p-Schicht (21) und wenigstens eine n-Schicht (22) hat, dadurch gekennzeichnet, dass das Halbleiter-Basismaterial (20, 40) zumindest teilweise aus Pyrit mit der chemischen Zusammensetzung FeS$_2$ besteht, welches zur Erzielung eines definierten Reinheitsgrades gereinigt ist.

2. Halbleiterbauelement nach Anspruch 1, dadurch gekennzeichnet, dass das Halbleiter-Basismaterial (40) aus wenigstens einer Schicht Pyrit (51), wenigstens einer Schicht Bor (52) und wenigstens einer Schicht Phosphor (53) zusammengesetzt ist.

3. Halbleiterbauelement nach Anspruch 2, dadurch gekennzeichnet, dass bei dem Halbleiter-Basismaterial (40) die wenigstens eine Schicht Pyrit (51) auf der Aussenseite, die einwirkende Strahlung als erste aufnehmende, nachfolgend die wenigstens eine Schicht Bor (52), und anschliessend die wenigstens eine Schicht Phosphor (53) angeordnet ist.

4. Halbleiterbauelement nach Anspruch 2, dadurch gekennzeichnet, dass bei dem Halbleiter-Basismaterial die wenigstens eine Schicht Bor und/oder die wenigstens eine Schicht Phosphor quer in der Schicht Pyrit angeordnet sind.

5. Halbleiterbauelement nach Anspruch 1, dadurch gekennzeichnet, dass bei einem mehrschichtigen Halbleiter-Basismaterial wenigstens eine p- oder n-Schicht aus Pyrit (31) und wenigstens eine n- oder p-Schicht aus einem andern Halbleiter (32) vorgesehen ist.

6. Halbleiterbauelement nach Anspruch 5, dadurch gekennzeichnet, dass für die Dotierung des Pyrit eines oder mehrere der Elemente S, O, N, H, Sn, C, Si, Co verwendbar ist.

7. Halbleiterbauelement nach Anspruch 1 oder 2, dadurch gekennzeichnet, dass für die Dotierung der p-Schicht (21) des Pyrits anstelle von in diesem enthaltenen Schwefelatomen Elemente aus der Gruppe V des Periodensystems, insbesondere Phosphor, Antimon oder Arsen eingebaut sind.

8. Halbleiterbauelement nach Anspruch 5, 6 oder 7, dadurch gekennzeichnet, dass die Konzentration der in das Halbleiter-Basismaterial (20, 40) eingebauten Elemente für die Erzeugung der n- bzw. p-Schicht (21) jeweils zwischen 0.001 und 20 Massen-Prozente beträgt.

9. Halbleiterbauelement nach einem der vorhergehenden Ansprüche, dadurch gekennzeichnet, dass das Halbleiter-Bauelement als Ein- oder Mehrschicht-Solarzelle, als Dünnfilm-Solarzelle, als MIS-Solarzelle, als photochemische Zelle oder dergleichen ausgebildet ist.

10. Halbleiterbauelement nach einem der vorhergehenden Ansprüche, dadurch gekennzeichnet, dass der Pyrit einen thermischen Ausdehnungskoeffizienten bei 90 bis 300 K von 4.5x10$^{-6}$ K$^{-1}$ und bei 300 bis 500 K von 8.4x10$^{-6}$ K$^{-1}$ aufweist.

11. Halbleiterbauelement nach einem der vorhergehenden Ansprüche, dadurch gekennzeichnet, dass der die chemische Zusammensetzung FeS$_2$ aufweisende Pyrit eine Elementarzelle von 12 Atomen und eine Länge der Einheitszelle von annähernd 5.4185 Angström hat, wobei die Grundformen des Kristallhabitus des Pyrits als Würfel, als kubische Form, als Pentagondodekaeder oder als Oktaeder auftreten.

12. Halbleiterbauelement nach einem der vorhergehenden Ansprüche, dadurch gekennzeichnet, dass das aus Pyrit gebildete HalbleiterBasismaterial mehrfach zonengereinigt ist und vorzugsweise einen Reinheitsgrad von 99,9 $\overline{9}$% aufweist.

13. Halbleiterbauelement nach einem der vorhergehenden Ansprüche, dadurch gekennzeichnet, dass das Halbleiterbauelement bei einer mehrschichtigen Struktur bis zu annähernd hundert Schichten aufweist.

14. Verfahren zur Herstellung eines Halbleiterbauelementes nach einem der vorhergehenden Ansprüche, dadurch gekennzeichnet, dass für das Halbleiter-Basismaterial entweder ein natürlich vorkommender Pyrit oder eine aus Eisen und Schwefel synthetisch hergestellte Verbindung in der chemischen Zusammensetzung $FeS_2$ verwendet wird.

15. Verfahren nach Anspruch 14, dadurch gekennzeichnet, dass das Pyrit bzw. die Ausgangsmaterialien Eisen und Schwefel bei synthetisch hergestelltem Pyrit zur Erzielung eines hohen Reinheitsgrades von 99,9 $\overline{9}$% mehrfach zonengereinigt sind.

16. Verfahren nach Anspruch 14 oder 15, dadurch gekennzeichnet, dass das Pyrit durch eine Hydrothermal-Methode, durch eine nass-chemische Methode (CVT) hergestellt wird.

17. Verfahren nach Anspruch 14 oder 15, dadurch gekennzeichnet, dass das Pyrit durch eine Tellur-, eine $NaS_2$- oder $FeCl_2$ Schmelze-Methode hergestellt wird.

18. Verfahren nach Anspruch 14 oder 15, dadurch gekennzeichnet, dass das Pyrit durch die Methode eines Gasphasentransportes hergestellt und/oder dotiert wird.

19. Verfahren nach Anspruch 18, dadurch gekennzeichnet, dass beim Gasphasentransport das Transportmittel $Br_2$ verwendet wird.

20. Verfahren nach Anspruch 18, dadurch gekennzeichnet, dass die Herstellung des Pyrit über eine Plasmasulfidation, eine thermische Sulfidation, ein MOCVD-Verfahren, reaktives Sputtern, Spray-Pyrolyse oder über ein anderes Verfahren erfolgt.

Fig.1

Fig.2

# Fig.3

# Fig.4

Europäisches
Patentamt

**EUROPÄISCHER RECHERCHENBERICHT**

Nummer der Anmeldung

EP 98 81 0382

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (int.Cl.6) |
|---|---|---|---|
| X | EP 0 173 642 A (HAHN MEITNER KERNFORSCH) 5.März 1986 * das ganze Dokument * | 1-20 | H01L31/032 C30B25/00 C30B25/02 C30B29/46 |
| X | ENNAOUI A ET AL: "IRON DISULFIDE FOR SOLAR ENERGY CONVERSION" SOLAR ENERGY MATERIALS AND SOLAR CELLS, Bd. 29, Nr. 4, 1.Mai 1993, Seiten 289-370, XP000361625 * Seite 354 - Seite 366; Tabelle I * * Seite 310; Tabelle 7 * | 1-20 | |
| | | | RECHERCHIERTE SACHGEBIETE (Int.Cl.6) H01L |

Der vorliegende Recherchenbericht wurde für alle Patentansprüche erstellt

| Recherchenort | Abschlußdatum der Recherche | Prüfer |
|---|---|---|
| MÜNCHEN | 4.August 1998 | Eliasson, G |

KATEGORIE DER GENANNTEN DOKUMENTE

X von besonderer Bedeutung allein betrachtet
Y von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03 82 (P04C03)

**ANHANG ZUM EUROPÄISCHEN RECHERCHENBERICHT**
**ÜBER DIE EUROPÄISCHE PATENTANMELDUNG NR.**                    EP 98 81 0382

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

                                                                04-08-1998

| Im Recherchenbericht angeführtes Patentdokument | Datum der Veröffentlichung | Mitglied(er) der Patentfamilie | Datum der Veröffentlichung |
|---|---|---|---|
| EP 0173642 A | 05-03-1986 | AU 574810 B | 14-07-1988 |
| | | AU 4526585 A | 30-01-1986 |
| | | CA 1265922 A | 20-02-1990 |
| | | DE 3526910 A | 13-02-1986 |
| | | JP 1814019 C | 18-01-1994 |
| | | JP 5024118 B | 06-04-1993 |
| | | JP 61106499 A | 24-05-1986 |
| | | US 4649227 A | 10-03-1987 |

EPO FORM P0461

Für nähere Einzelheiten zu diesem Anhang : siehe Amtsblatt des Europäischen Patentamts. Nr.12/82